# EUROPEAN PATENT APPLICATION

(11) **EP 4 678 457 A1**
(43) Date of publication of application: **14.01.2026**
(21) Application number: 24767289.2
(22) Date of filing: 26.01.2024
(51) Int. Cl.: B60L 3/00, B60L 53/24, B60L 58/12, B60L 53/62, B60L 58/16, G01R 31/382, G01R 31/392

(54) **ELECTRIC VEHICLE CHARGING DEVICE FOR SAFELY AND EFFICIENTLY CHARGING ELECTRIC VEHICLE BY BEING EQUIPPED WITH ELECTRIC VEHICLE FIRE PREVENTION FUNCTION AND BATTERY PERFORMANCE EVALUATION FUNCTION, AND METHOD USING SAME**

(30) Priority: 03.03.2023 KR 20230028783
(71) Applicant: Starkoff Co., Ltd., Seoul 04789 (KR)
(72) Inventor: AHN, Tae Hyo, Seoul 04076 (KR); AHN, Hyun Kwon, Seoul 08758 (KR); KIM, Hong Mo, Gwangmyeong-si Gyeonggi-do 14316 (KR); JOO, Kwang Min, Yongin-si Gyeonggi-do 16875 (KR)
(74) Representative: Vossius & Partner Patentanwälte Rechtsanwälte mbB
(86) International application number: PCT/KR2024/001271
(87) International publication number: WO 2024/186000

(57) **Abstract**

Disclosed are: a method for safely and efficiently charging an electric vehicle using an electric vehicle charging device equipped with an electric vehicle battery fire prevention function and performance evaluation function; and an electric vehicle charging device. The method comprises the steps in which: (a) after an electric vehicle is connected to an electric vehicle charging device, the electric vehicle charging device starts charging a battery of the electric vehicle in a constant current charging mode in which charging is carried out in a state where a charging current is maintained at a constant; and (b) the electric vehicle charging device repeats the process, while increasing t, of measuring, from time point t to time point (t+1), the voltage value at time t which is the charging voltage at both ends of the battery of the electric vehicle, and a current value at time t which is the charging current flowing in the battery of the electric vehicle, and in consideration of the voltage value at time t, current value at time t, and time points t and (t+1) to acquire power amount information at time t, wherein, in step (b), if the electric vehicle charging device detects that, during the repetition while increasing t from k to k+z, the state of charge (SOC) of the battery of the electric vehicle has reached a preset first critical capacity when t equals k+m where m is an integer from 0 to z inclusive, the electric vehicle charging device detects that the charging mode has been switched from the constant current charging mode to a constant voltage charging mode in which charging is carried out in a state where the charging voltage is maintained at a predetermined constant voltage or is varied within a predetermined critical range with respect to the predetermined voltage.

## Description

The present disclosure relates to an electric vehicle charging device, and more particularly, to an electric vehicle charging device for safely and efficiently charging an electric vehicle by being equipped with an electric vehicle fire prevention function and a battery performance evaluation function, and a method using the same.

Recently, as the electric vehicles has earned increasing interests and as more people use the electric vehicles, fire due to the electric vehicle is emerging as an issue. Such fire of the electric vehicle mostly starts from the built-in battery, and the main reasons for the fire include internal short circuit due to manufacturing problem, damage to a battery pack due to collision such as a traffic accident, and aging of the battery due to repeated overcharging.

In this regard, according to the report about fire response of the electric vehicle published on November 2021, except the fire caused by traffic accidents, the number of cases of fire caused by electric vehicle battery is 17 cases as of July 2021, starting from the electric vehicle fire at Hyundai Motor Company's Ulsan plant in May 2018. To be specific, in case of charging in summer, the fire usually occurs during rapid charging (DC), and specifically, the fire mostly occurs almost at the end of the rapid charging or after the end thereof.

Also, according to the fire occurrence rate per 10,000 vehicles in 2020, the fire rate per 10,000 internal combustion engine vehicles is 1.88, and the fire rate per 10,000 electric vehicles is 1.63. By excluding the fires due to the traffic accidents of the electric vehicles, the fire rate per 10,000 electric vehicles is 0.52, which is lower rate than the internal combustion engine vehicles. However, if the fire occurs in the electric vehicle, it is more difficult to extinguish the fire, and it takes longer time to extinguish.

On the other hand, if the fire occurs in the electric vehicle, as a method of extinguishing the fire of the electric vehicle at a frontline fire station, there are cooling extinguishing using a water cooler, suffocation extinguishing using a suffocation extinguishing cover, and cooling extinguishing using a portable water tank. However, in case of using the water cooler, it is not very effective since the battery is embedded inside the vehicle body, and in case of using a suffocation extinguishing cover, combustible gases and flammable gases which are generated as the lithium battery decomposes in the high-temperature environment may leak, resulting in a decrease of extinguishing ability. Further, in case of using a portable water tank, it takes too long to extinguish, and thus there is no actual clear fire response plan.

Therefore, improvement is required to safely use the electric vehicle by extending a battery life through a prevention of aging and overcharging of the electric vehicle battery, and a prevention of fire of the electric vehicle battery.

It is an object of the present disclosure to solve all the aforementioned problems.

It is another object of the present disclosure to provide a function for controlling the charging rate of the electric battery by detecting that a predetermined first threshold capacity is reached during a constant current charging mode and then by detecting the change from the constant current charging mode to a constant voltage charging mode where a charging voltage is maintained constantly.

It is still another object of the present disclosure to provide an electric vehicle charging device for providing a function of preventing the fire by stopping charging of the electric vehicle battery at an appropriate timing when it is detected that it has reached a predetermined second threshold capacity, while charging in the constant voltage charging mode, during a safety mode.

It is still yet another object of the present disclosure to provide the electric vehicle charging device for effectively estimating the state of health of the electric vehicle battery by referring to the data of repeated charging cycles of the electric vehicle battery, and resetting the first threshold capacity based on the estimated state of health of the battery.

It is still yet another object of the present disclosure to provide the electric vehicle charging device for effectively evaluating the state of health of the electric vehicle battery of each cycle by referring to each of frequency ranges, each of amplitudes, and each piece of spectrum information obtained from the data of the repeated charging cycles of the electric vehicle battery.

In order to accomplish the objects above, distinctive structures of the present disclosure are described as follows.

In accordance with one aspect of the present disclosure, there is provided a method for safely and efficiently charging an electric vehicle using an electric vehicle charging device equipped with an electric vehicle fire prevention function and a battery performance evaluation function, comprising steps of: (a) after the electric vehicle is connected to the electric vehicle charging device, the electric vehicle charging device starting a charging of an electric vehicle battery in a constant current charging mode in which a charging current is maintained to be constant; and (b) the electric vehicle charging device repeating sub-processes of (i) measuring a t-th voltage which is a charging voltage applied between both ends of the electric vehicle battery from a t-th time to a (t+1)-th time and a t-th current which is the charging current flowing through the electric vehicle battery from the t-th time to the (t+1)-th time, and (ii) obtaining t-th electric energy information by referring to the t-th voltage, the t-th current, the t-th time and the (t+1)-th time, while increasing a value of t; wherein, at the step of (b), during repeating the sub-processes while increasing the value of t from k to k+z, when the value of t is k+m, wherein m is an integer larger than or equal to 0 and smaller than or equal to z, and when it is detected that a state of charge (SOC) of the electric vehicle battery has reached a predetermined first threshold capacity, the electric vehicle charging device changes its mode from the constant current charging mode to a constant voltage charging mode, wherein, in the constant voltage charging mode, the electric vehicle is charged with the charging voltage being maintained constantly as a specific voltage or with the charging voltage being changed within a specific threshold range.

As one example, the method further comprises a step of: (c) during repeating the sub-processes while increasing the value of t from k to k+z, when the value of t is k+n, wherein n is an integer larger than or equal to 1 and smaller than or equal to z, and when it is detected that the state of charge of the electric vehicle battery has reached a predetermined second threshold capacity, the electric vehicle charging device supporting to stop charging the electric vehicle battery.

As one example, the method further comprises a step of: (d) after repeating charging and discharging for a first cycle to an s-th cycle, wherein s is an integer larger than or equal to 1, the electric vehicle charging device (d1) estimating an s-th state of health (SOH) which is a ratio of an s-th maximum charging capacity to a first maximum charging capacity, by referring to (i) a (1_t)-th voltage and a (1_t)-th current measured from a (1_t)-th time to a (1_(t+1))-th time of a charging of the first cycle and (1_t)-th electric energy information obtained from the (1_t)-th voltage, the (1_t)-th current, the (1_t)-th time and the (1_(t+1))-th time, and (ii) an (s_t)-th voltage and an (s_t)-th current measured from an (s_t)-th time to an (s_(t+1))-th time of a charging of the s-th cycle and (s_t)-th electric energy information obtained from the (s_t)-th voltage, the (s_t)-th current, the (s_t)-th time and the (s_(t+1))-th time, and (d2) the electric vehicle charging device resetting the first threshold capacity to be a (1_s)-th threshold capacity for a charging of an (s+1)-th cycle of the electric vehicle battery by referring to the s-th state of health.

As one example, the method further comprises a step of: (e) after repeating charging and discharging from a first cycle to an s-th cycle, the electric vehicle charging device (e1) performing a sub-process of measuring of a (1_t)-th current from a (1_t)-th time to a (1_(t+1))-th time of a charging of the first cycle to a sub-process of measuring an (s_t)-th current from an (s_t)-th time to an (s_(t+1))-th time of a charging of the s-th cycle, (e2) obtaining each of frequency ranges, each of amplitudes, and each piece of spectrum information of each of the (1_t)-th voltage to the (s_t)-th voltage, and (e3) estimating a state of health of the electric vehicle battery at each cycle by referring to each of the frequency ranges, each of the amplitudes, and each piece of the spectrum information of each of the (1_t)-th voltage to the (s_t)-th voltage.

As one example, at the step of (b), in the constant current charging mode, during repeating the sub-processes while increasing the value of t from k to k+m, the electric vehicle charging device increases the charging voltage applied between the both ends of the electric vehicle battery by maintaining the charging current of the electric vehicle battery to be constant, and when it is detected that the charging voltage has reached a predetermined safety charging end voltage for a fire prevention and an extended life of the electric vehicle battery, the electric vehicle charging device detects that its mode has been changed from the constant current charging mode to the constant voltage charging mode.

As one example, at the step of (b), when there are g number of units which are counted as one group in a section of k to k+z which is a total section about t, and when an i-th grouping section is where the value of t is from (i-1)*g to i*(g-1), during repeating the sub-processes while increasing the value of t from (i-1)*g to i*(g-1), the electric vehicle charging device additionally obtains accumulated electric energy information for an i-th group which is an accumulation of each of (i-1)*g-th electric energy information at a time of t being (i-1)*g to i*(g-1)-th electric energy information at a time of t being i*(g-1), and wherein the electric vehicle charging device stores and manages the (i-1)*g-th voltage to the i*(g-1)-th voltage, the (i-1)*g-th current to the i*(g-1)-th current, the (i-1)*g-th electric energy information to the i*(g-1)-th electric energy information and the accumulated electric energy information for the i-th group in a database.

As one example, by referring to the database which manages each piece of optimal charging and discharging range information for each of multiple electric vehicle batteries, wherein each piece of the optimal charging and discharging range information is matched with at least part of: car types of multiple electric vehicles, types of multiple electric vehicle batteries, uses of the multiple electric vehicles, multiple pieces of usage information of the multiple electric vehicle batteries, temperatures of the multiple electric vehicle batteries while charging and discharging, the electric vehicle charging device obtains specific optimal charging and discharging range information which is matched with at least part of: the car type of the electric vehicle, the type of the electric vehicle battery, the use of the electric vehicles, the usage information of the electric vehicle battery, the temperature of the electric vehicle battery while charging and discharging, and wherein, while monitoring the (i-1)*g-th electric energy information to the i*(g-1)-th electric energy information and the accumulated electric energy information for the i-th group, when it is detected to be an upper threshold corresponding to the specific optimal charging and discharging range information of the electric vehicle battery, the electric vehicle charging device supports to stop the charging of the electric vehicle battery, and when it is detected to be a lower threshold corresponding to the specific optimal charging and discharging range information of the electric vehicle battery, the electric vehicle charging device supports to stop the discharging of the electric vehicle battery and start a new cycle of charging.

As one example, before the step of (a), the method further comprises a step of: (a0) when it is detected that the electric vehicle is connected to the electric vehicle charging device, the electric vehicle charging device (a01) automatically selecting one of a safety mode which is a mode that is capable of charging the electric vehicle battery safely by applying the electric vehicle fire prevention function and a long distance mode which is a mode that can charge up to a maximum charge capacity of the electric vehicle battery for a long distance driving of the electric vehicle, or (a02) supporting a user of the electric vehicle to select one of the safety mode and the long distance mode; wherein, (i) when it is detected that the safety mode is selected, the electric vehicle charging device performs the steps (a) and (b), and during repeating the sub-processes while increasing the value of t from k to k+z, when the value of t is k+n and when it is detected that the state of charge of the electric vehicle battery has reached a predetermined second threshold capacity, the electric vehicle charging device stops the charging of the electric vehicle, and (ii) when it is detected that the long distance mode is selected, the electric vehicle charging device performs the steps (a) and (b), and during repeating the processes while increasing the value of t from k to k+z, when the value of t is k+n, the electric vehicle charging device continues charging without detecting whether the state of charge of the electric vehicle battery reaches the predetermined second threshold capacity or not.

**In** accordance with another aspect of the present disclosure, there is provided an electric vehicle charging device being equipped with an electric vehicle fire prevention function and a battery performance evaluation function, comprising: at least one memory that stores instructions; and at least one processor configured to execute the instructions to perform or support another device to perform processes of: (I) after the electric vehicle is connected to the electric vehicle charging device, the electric vehicle charging device starting a charging of an electric vehicle battery in a constant current charging mode in which a charging current is maintained to be constant; and (II) the electric vehicle charging device repeating sub-processes of (i) measuring a t-th voltage which is a charging voltage applied between both ends of the electric vehicle battery from a t-th time to a (t+1)-th time and a t-th current which is the charging current flowing through the electric vehicle battery from the t-th time to the (t+1)-th time, and (ii) obtaining t-th electric energy information by referring to the t-th voltage, the t-th current, the t-th time and the (t+1)-th time, while increasing a value of t; wherein, at the process (II), during repeating the sub-processes while increasing the value of t from k to k+z, when the value of t is k+m, wherein m is an integer larger than or equal to 0 and smaller than or equal to z, and when it is detected that a state of charge (SOC) of the electric vehicle battery has reached a predetermined first threshold capacity, the electric vehicle charging device changes its mode from the constant current charging mode to a constant voltage charging mode, wherein, in the constant voltage charging mode, the electric vehicle is charged with the charging voltage being maintained constantly as a specific voltage or with the charging voltage being changed within a specific threshold range.

As one example, the processor further performs a process of: (III) during repeating the sub-processes while increasing the value of t from k to k+z, when the value of t is k+n, wherein n is an integer larger than or equal to 1 and smaller than or equal to z, and when it is detected that the state of charge of the electric vehicle battery has reached a predetermined second threshold capacity, the electric vehicle charging device supporting to stop charging the electric vehicle battery.

As one example, the processor further performs a process of: (IV) after repeating charging and discharging for a first cycle to an s-th cycle, wherein s is an integer larger than or equal to 1, the electric vehicle charging device (IV-1) estimating an s-th state of health (SOH) which is a ratio of an s-th maximum charging capacity to a first maximum charging capacity, by referring to (i) a (1_t)-th voltage and a (1_t)-th current measured from a (1_t)-th time to a (1_(t+1))-th time of a charging of the first cycle and (1_t)-th electric energy information obtained from the (1_t)-th voltage, the (1_t)-th current, the (1_t)-th time and the (1_(t+1))-th time, and (ii) an (s_t)-th voltage and an (s_t)-th current measured from an (s_t)-th time to an (s_(t+1))-th time of a charging of the s-th cycle and (s_t)-th electric energy information obtained from the (s_t)-th voltage, the (s_t)-th current, the (s_t)-th time and the (s_(t+1))-th time, and (IV-2) the electric vehicle charging device resetting the first threshold capacity to be a (1_s)-th threshold capacity for a charging of an (s+1)-th cycle of the electric vehicle battery by referring to the s-th state of health.

As one example, the processor further performs a process of: (V) after repeating charging and discharging from a first cycle to an s-th cycle, the electric vehicle charging device (V-1) performing a sub-process of measuring of a (1_t)-th current from a (1_t)-th time to a (1_(t+1))-th time of a charging of the first cycle to a sub-process of measuring an (s_t)-th current from an (s_t)-th time to an (s_(t+1))-th time of a charging of the s-th cycle, (V-2) obtaining each of frequency ranges, each of amplitudes, and each piece of spectrum information of each of the (1_t)-th voltage to the (s_t)-th voltage, and (V-3) estimating a state of health of the electric vehicle battery at each cycle by referring to each of the frequency ranges, each of the amplitudes, and each piece of the spectrum information of each of the (1_t)-th voltage to the (s_t)-th voltage.

As one example, at the process of (II), in the constant current charging mode, during repeating the sub-processes while increasing the value of t from k to k+m, the electric vehicle charging device increases the charging voltage applied between the both ends of the electric vehicle battery by maintaining the charging current of the electric vehicle battery to be constant, and when it is detected that the charging voltage has reached a predetermined safety charging end voltage for a fire prevention and an extended life of the electric vehicle battery, the electric vehicle charging device detects that its mode has been changed from the constant current charging mode to the constant voltage charging mode.

As one example, at the process of (II), when there are g number of units which are counted as one group in a section of k to k+z which is a total section about t, and when an i-th grouping section is where the value of t is from (i-1)*g to i*(g-1), during repeating the sub-processes while increasing the value of t from (i-1)*g to i*(g-1), the electric vehicle charging device additionally obtains accumulated electric energy information for an i-th group which is an accumulation of each of (i-1)*g-th electric energy information at a time of t being (i-1)*g to i*(g-1)-th electric energy information at a time of t being i*(g-1), and wherein the electric vehicle charging device stores and manages the (i-1)*g-th voltage to the i*(g-1)-th voltage, the (i-1)*g-th current to the i*(g-1)-th current, the (i-1)*g-th electric energy information to the i*(g-1)-th electric energy information and the accumulated electric energy information for the i-th group in a database.

As one example, by referring to the database which manages each piece of optimal charging and discharging range information for each of multiple electric vehicle batteries, wherein each piece of the optimal charging and discharging range information is matched with at least part of: car types of multiple electric vehicles, types of multiple electric vehicle batteries, uses of the multiple electric vehicles, multiple pieces of usage information of the multiple electric vehicle batteries, temperatures of the multiple electric vehicle batteries while charging and discharging, the electric vehicle charging device obtains specific optimal charging and discharging range information which is matched with at least part of: the car type of the electric vehicle, the type of the electric vehicle battery, the use of the electric vehicles, the usage information of the electric vehicle battery, the temperature of the electric vehicle battery while charging and discharging, and wherein, while monitoring the (i-1)*g-th electric energy information to the i*(g-1)-th electric energy information and the accumulated electric energy information for the i-th group, when it is detected to be an upper threshold corresponding to the specific optimal charging and discharging range information of the electric vehicle battery, the electric vehicle charging device supports to stop the charging of the electric vehicle battery, and when it is detected to be a lower threshold corresponding to the specific optimal charging and discharging range information of the electric vehicle battery, the electric vehicle charging device supports to stop the discharging of the electric vehicle battery and start a new cycle of charging.

As one example, before the process of (I), the processor further performs a process of: (I-0) when it is detected that the electric vehicle is connected to the electric vehicle charging device, the electric vehicle charging device (I-01) automatically selecting one of a safety mode which is a mode that is capable of charging the electric vehicle battery safely by applying the electric vehicle fire prevention function and a long distance mode which is a mode that can charge up to a maximum charge capacity of the electric vehicle battery for a long distance driving of the electric vehicle, or (I-02) supporting a user of the electric vehicle to select one of the safety mode and the long distance mode; wherein, (i) when it is detected that the safety mode is selected, the electric vehicle charging device performs the processes (I) and (II), and during repeating the sub-processes while increasing the value of t from k to k+z, when the value of t is k+n and when it is detected that the state of charge of the electric vehicle battery has reached a predetermined second threshold capacity, the electric vehicle charging device stops the charging of the electric vehicle, and (ii) when it is detected that the long distance mode is selected, the electric vehicle charging device performs the steps (a) and (b), and during repeating the processes while increasing the value of t from k to k+z, when the value of t is k+n, the electric vehicle charging device continues charging without detecting whether the state of charge of the electric vehicle battery reaches the predetermined second threshold capacity or not.
Fig. 1 is a drawing schematically illustrating an electric vehicle charging device equipped with an electric vehicle fire prevention function and a battery performance evaluation function in accordance with one example embodiment of the present disclosure.
Fig. 2 is a drawing illustrating a detailed structure of the electric vehicle charging device in accordance with one example embodiment of the present disclosure in more detail.
Fig. 3 is a drawing schematically illustrating a process of the electric vehicle charging device obtaining each voltage, each current, each piece of electric energy information and each piece of accumulated electric energy information for each group from the voltage and the current measured at each grouping section in accordance with one example embodiment of the present disclosure.
Fig. 4 is a drawing schematically illustrating a result data acquired by analyzing the electric energy information of the electric vehicle charging device in accordance with one example embodiment of the present disclosure charging the electric vehicle.
Fig. 5 is a drawing schematically illustrating a result data acquired by measuring a battery life of the electric vehicle battery with different ranges of a charging and discharging of the electric vehicle by the electric vehicle charging device in accordance with one example embodiment of the present disclosure.
Fig. 6 is a drawing schematically illustrating a system for charging the electric vehicle in accordance with one example embodiment of the present disclosure.

In the following detailed description, reference is made to the accompanying drawings that show, by way of illustration, specific embodiments in which the invention may be practiced. These embodiments are described in sufficient detail to enable those skilled in the art to practice the invention. It is to be understood that the various embodiments of the present invention, although different, are not necessarily mutually exclusive. For example, a particular feature, structure, or characteristic described herein in connection with one embodiment may be implemented within other embodiments without departing from the spirit and scope of the present invention.

In addition, it is to be understood that the position or arrangement of individual elements within each disclosed embodiment may be modified without departing from the spirit and scope of the present invention. The following detailed description is, therefore, not to be taken in a limiting sense, and the scope of the present invention is defined only by the appended claims, appropriately interpreted, along with the full range of equivalents to which the claims are entitled. In the drawings, like numerals refer to the same or similar functionality throughout the several views.

The headings and abstract of the present disclosure provided herein are for convenience only and do not limit or interpret the scope or meaning of the embodiments.

For reference, as used in this specification and the appended claims, the singular forms "a," "an," and "the" may include plural referents unless the content and context clearly dictates otherwise.

To allow those skilled in the art to carry out the present invention easily, the example embodiments of the present invention by referring to attached diagrams will be explained in detail as shown below.

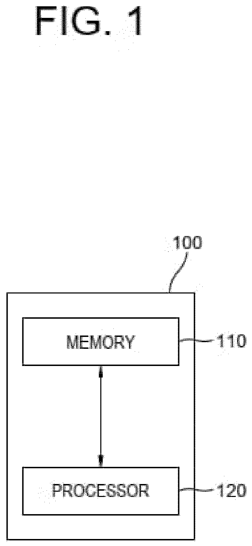

Fig. 1 is a drawing schematically illustrating an electric vehicle charging device equipped with an electric vehicle fire prevention function and a battery performance evaluation function in accordance with one example embodiment of the present disclosure.

Firstly, by referring to Fig. 1, it is a drawing schematically illustrating an electric vehicle charging device 100 including: a memory 110 which stores instructions related to a fire prevention function and a battery performance evaluation function to safely and efficiently charge the electric vehicle, and a processor 120 which performs processes related to the fire prevention function and the battery performance evaluation function to safely and efficiently charge the electric vehicle in response to the instructions stored in the memory 110.

Specifically, the electric vehicle charging device 100 may typically achieve a required system performance by using combinations of (i) at least one computing device, e.g., a computer processor, a memory, a storage, an input device, an output device, or any other conventional computing components, an electronic communication device such as a router or a switch, an electronic information storage system such as a network-attached storage (NAS) device and a storage area network (SAN) and (ii) at least one computer software such as any instructions that allow the computing device to function in a specific way.

Also, the processor of the computing device may include hardware configuration of MPU (Micro Processing Unit) or CPU (Central Processing Unit), cache memory, data bus, etc. Additionally, the computing device may further include software configuration of OS and applications that achieve specific purposes.

However, the case in which the computing device includes an integrated processor, which includes a medium, a processor and a memory, for implementing the present disclosure is not excluded.

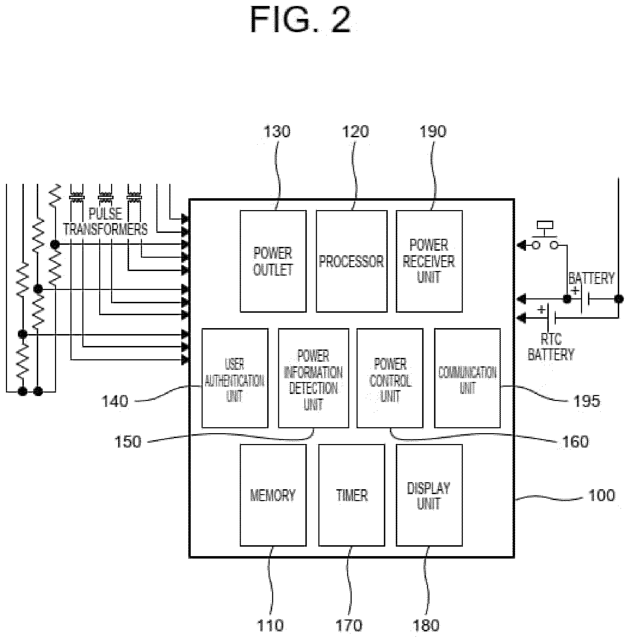

Fig. 2 is a drawing illustrating a detailed structure of the electric vehicle charging device in accordance with one example embodiment of the present disclosure in more detail.

Referring to Fig. 2, the electric vehicle charging device 100 may comprise a power outlet 130, a user authentication unit 140, a power information detection unit 150, a power control unit 160, a timer 170, a display unit 180, a power receiver unit 190 in addition to the memory 110 and processor 120 as mentioned above, and also, even if the electric vehicle charging device 100 does not include the power outlet 130, the user authentication unit 140, the power information detection unit 150, the power control unit 160, the timer 170, the display unit 180, the power receiver unit 190 etc. inside the device, it can be linked with or communicate with the power outlet 130, the user authentication unit 140, the power information detection unit 150, the power control unit 160, the timer 170, the display unit 180, the power receiver unit 190 etc. through a communication unit 195 of the electric vehicle charging device 100. Herein, the communication unit 195 may communicate with another device wired or wirelessly via AMR, IR, HOST, SPI INTERFACE of the electric vehicle charging device 100.

At least part of the user authentication unit 140, the power information detection unit 150, the power control unit 160, the timer 170, the display unit 180, the power receiver unit 190 can perform the functions in conjunction with the processor 120. For example, each of them can perform each function under given instructions by the processor 120.

Each element of the electric vehicle charging device will be described in detail below.

Firstly, the power receiver unit 190 can perform a function which receives a certain power from a power part which is illustrated at the right side of the Fig. 2, and the power receiver unit 190 can provide the received power to the electric vehicle via the power outlet 130. For this, the power outlet 130 can connect to the electric vehicle through the plug of the electric vehicle in order to provide power.

Next, the user authentication unit 140 can perform a function of receiving information on a user who wishes to charge the electric vehicle, and once the information on the user is verified, it can support the payment for the user, and it can also support to match and record the state of health of the electric vehicle (which will be explained later).

Also, when it is detected that the electric vehicle is connected to the power outlet 130 via the plug etc., the user authentication unit 140 can support the user to select one of (1) a safety mode which is a mode that is capable of charging the electric vehicle battery safely by applying the electric vehicle fire prevention function and (2) a long distance mode which is a mode that can charge up to a maximum charge capacity of the electric vehicle battery for a long distance driving of the electric vehicle, or it can support to automatically select predetermined mode. For example, as a default mode, it can support to charge in the safety mode, but when the user needs a long distance driving, it can support the user to select the long distance mode to charge up to the maximum charge capacity.

Further, through the user authentication unit 140, authentication information and payment information of the electric vehicle user can be inputted, and such information can be obtained from at least one of a magnetic card, an IC card, an RFID chip and a user keypad input. Herein, the IC card and the magnetic card can be a credit card, a charge card, a prepaid card, etc. that contain user identification information.

Next, the display unit 180 can be implemented as an LED or a display which can display a state of charge of the electric vehicle charging device 100, and by the display unit 180, authentication action of the electric vehicle and the information about the charged power according to the charging of the electric vehicle, etc. can be displayed. Of course, even if the display unit 180 is not included in the electric vehicle charging device 100, it is obvious that it can be implemented to be displayed through the display unit 180 of the terminal (such as a smartphone) corresponding to the user.

Next, the power information detection unit 150 can perform a function of detecting information from the power outlet 130 such as a voltage at both ends of the electric battery, current flowing through the electric battery etc., and obtaining power information, electric energy information therefrom.

Specifically, the power information detection unit 150 calculates an electric energy used in a resistor by measuring voltage and current readings of the resistor connected to the electric vehicle as illustrated at the left side of the electric vehicle charging device 100, and it may include a multiplexer (MUX) or an analog-to-digital converter (ADC) circuit (not shown) for converting an analog signal obtained from the power supply to a digital signal and processing the digital signal.

Next, the power control unit 160 can make a plurality of groups such that each of the groups includes a plurality of predetermined unit sections (which are included in the total time section of the charging of the electric vehicle) by referring to the time information obtained from the timer 170, and by storing and managing each voltage, each current, each piece of electric energy information obtained per each of the predetermined unit sections included in one group and accumulated electric energy information for the same group which is acquired by accumulating each piece of electric energy information per each unit section in the same group in a separate database (for example, the memory 110), it can estimate a charging curve of the electric battery during a charging process and accordingly allow the charging process to be stopped at an appropriate timing.

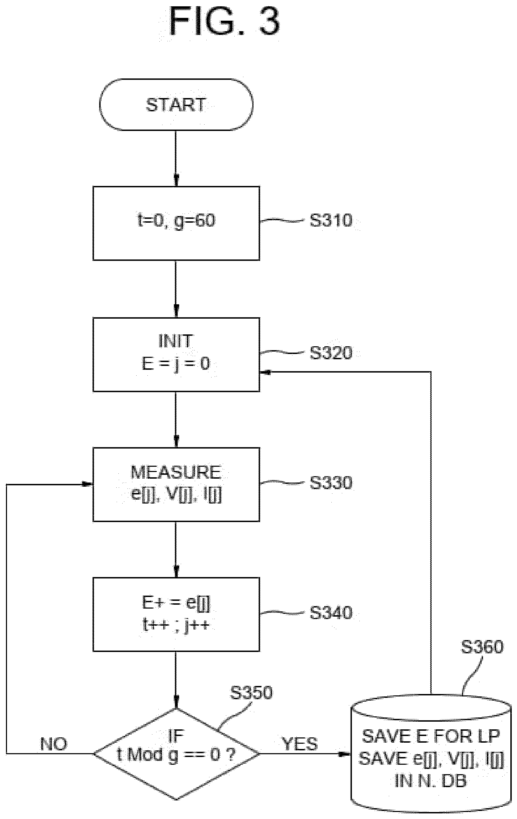

Regarding the operating process of the power control unit 160 for safe usage by preventing the fire of the electric vehicle battery through checking the charging curve of the electric vehicle battery and accordingly by stopping the charging at an appropriate timing, it will be described in detail later with reference to Fig. 3.

Meanwhile, the power control unit 160 and the power information detection unit 150 can be executed by the processor 120 which performs the operation of the electric vehicle charging device 100, for example, it can be controlled through software and/or hardware. Also, in some cases, it can be linked to the smartphone application of the user of the electric vehicle and support to check or control the operation or control status of at least part of the power control unit 160 and the power information detection unit 150.

Meanwhile, the electric vehicle charging device 100 can further include a temperature sensor (not shown) for detecting an internal temperature or an ambient temperature of the electric vehicle charging device 100.

For example, the electric vehicle charging device 100 can adjust and/or compensate the measured power information by referring to the temperature detected by the temperature sensor. That is, an error can occur in a value measured by the electric vehicle charging device 100 according to the internal temperature or the ambient temperature of the electric vehicle charging device 100. In order to reduce the error of the measured value, the electric vehicle charging device 100 can adjust and/or compensate the measured value by referring to the internal temperature or the ambient temperature detected by the temperature sensor.

Fig. 3 is a drawing schematically illustrating a process of the electric vehicle charging device obtaining each voltage, each current, each piece of electric energy information (also referred to as accumulated electric energy information for each unit section) and accumulated electric energy information for each group from the voltage and the current measured at each unit section included in each grouping section in accordance with one example embodiment of the present disclosure.

For reference, before performing the process of Fig. 3, below process may be performed.

For example, the user of the electric vehicle can connect to the power outlet 130 of the electric vehicle charging device 100 via plug etc. so that the electric vehicle connects to the electric vehicle charging device 100.

Herein, the electric vehicle charging device 100 can set, as a default mode, a safety mode which is a mode that is capable of charging the electric vehicle battery safely by applying the electric vehicle fire prevention function. However, when the user needs a long distance driving, it can support the user to select the long distance mode to charge up to the maximum charge capacity.

When it is detected that the safety mode is selected, the electric vehicle charging device 100 can start charging the electric vehicle battery in a constant current charging mode in which the charging current is maintained constantly through the plug connected at the power outlet 130.

Now referring to the Fig. 3 in detail, the electric vehicle charging device 100 can set the number of bundle of the unit time, i.e., the unit section, to be grouped before starting the charging for the electric vehicle battery (S310). Herein, the concept of grouping, which will be explained in detail later, is simply a bundle of multiple unit times in order to calculate an accumulated electric energy for each group, and the accumulated electric energy for each group can be calculated and recorded in the database.

For example, if g =60, when 1 second is a unit time, the accumulated electric energy information for one group will be stored in a database etc. when 60 unit times are collected as being included in one group.

Next, the electric vehicle charging device 100 can reset, i.e., initialize, an accumulated electric energy for one group E, and reset a factor j which is a factor for checking if it is repeated for 60 times (S320).

Next, the electric vehicle charging device 100 can measure a charging voltage applied between both ends of the electric vehicle battery and a charging current flowing through the electric vehicle battery during the unit time, and obtain an electric energy information (also referred to as accumulated electric energy information for each unit section : e[j]) with reference to the charging voltage, the charging current and the unit time (S330).

For such electric energy information for each unit section, if accumulated electric energy E exists, e[j] can be added to E, and if E is 0, e[j] can be updated as a value of E (S340). Herein, by increasing the factor j and checking if 60 unit times have been repeated (S350), in case 60 unit times are not repeated, it can go back to step S330, and measure a charging voltage applied between both ends of the electric vehicle battery and a charging current flowing through the electric vehicle battery during the next unit time, and obtain electric energy information for each unit section with reference to the charging voltage, the charging current and the unit time (S330).

To explain this iterative process generally, it includes repetitive sub-processes of (i) measuring a t-th voltage which is a charging voltage applied between both ends of the electric vehicle battery from a t-th time to a (t+1)-th time and a t-th current which is the charging current flowing through the electric vehicle battery from the t-th time to the (t+1)-th time, and (ii) obtaining t-th electric energy information by referring to the t-th voltage, the t-th current, the t-th time and the (t+1)-th time, while increasing a value of t.

As a result of the repetition, if it is determined that 60 unit times have been repeated, accumulated electric energy information for one group which is addition of accumulated electric energy information for 60 unit sections can be recorded on the database (S360). Herein, each piece of the accumulated electric energy information for each time section and each of the corresponding voltages and currents can be recorded on the database. Herein, the database can be the memory 110, but it is not limited thereto.

During the repetition of S330 to S350, the timing when the mode is changed from the constant current charging mode to the constant voltage charging mode can be detected.

Specifically, during repeating the sub-processes while increasing the value of t from k to k+z, if it is detected that a state of charge (SOC) of the electric vehicle battery has reached a predetermined first threshold capacity when the value of t is k+m, wherein m is an integer larger than or equal to 0 and smaller than or equal to z, the processor 120 of the electric vehicle charging device 100 can instruct the power control unit 160 to detect change of the mode from the constant current charging mode to a constant voltage charging mode (where the electric vehicle is charged with the charging voltage being maintained constantly as a specific voltage or with the charging voltage being changed within a specific threshold range).

As one example, when the electric vehicle is charged in a constant current charging mode and accordingly the power control unit 160 of the electric vehicle charging device 100 detects that the SOC is 82%, it can detect the change of the mode to the constant voltage charging mode to safely charge at a level where a fire does not occur in the electric vehicle battery.

Also, when it is detected that the charging voltage has reached a predetermined safety charging end voltage for a fire prevention and an extended life of the electric vehicle battery, the electric vehicle charging device 100 detects that its mode has been changed from the constant current charging mode to the constant voltage charging mode.

As one example, for a lithium ion battery which is used for the electric vehicle battery, when the charging starts at the discharged state, in the beginning, the voltage applied at the both ends of the electric vehicle battery increases while maintaining a constant current value for a fast charging. However, if the voltage exceeds a certain value, although the charging speed increases, the battery life decreases sharply.

Thus, the electric vehicle charging device 100 of the present disclosure can detect the change from the constant current charging mode to the constant voltage charging mode when it is detected that the voltage applied to the both ends of the electric vehicle battery has reached a predetermined safety charging end voltage. Herein, the safety charging end voltage can be set differently per each model of electric vehicle and per each period such as summer or winter, but not limited thereto.

Also, during repeating the sub-processes while increasing the value of t from k to k+z, if it is detected that the state of charge of the electric vehicle battery has reached a predetermined second threshold capacity when the value of t is k+n, the electric vehicle charging device 100 can support to stop the charging of the electric vehicle.

As one example, when it is detected that a state of charge (SOC) of the electric vehicle battery has reached a predetermined first threshold capacity (for example, 82%), the power control unit of the electric vehicle charging device 100 can detect the change of its mode from the constant current charging mode to the constant voltage charging mode, and when the SOC of the electric vehicle battery has reached about 85% after charging, it can support to stop the charging of the electric vehicle battery so that it prevents the fire of the electric vehicle battery and extends the life of the electric vehicle battery.

However, while the user of the electric vehicle connects the electric vehicle to the electric vehicle charging device 100 by using a plug, when it is detected that a long distance mode for a long distance driving is selected by the user of the electric vehicle, the electric vehicle charging device 100 continues charging in the constant current charging mode and detects that it has reached a predetermined first threshold capacity (for example, 82%) or the safety charging end voltage and changed to the constant voltage charging mode, and the electric vehicle charging device 100 may continue the charging until the SOC reaches 100%, without detecting the reaching of the second threshold capacity (for example, 85%).

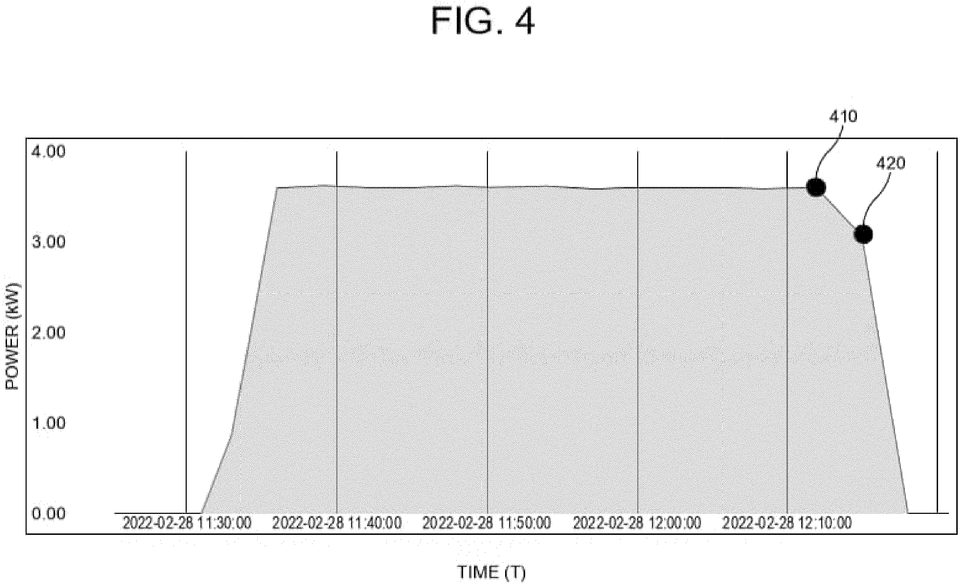

As such, the examples of the result data of the charging performed after the electric vehicle charging device 100 being connected to the electric vehicle will be described later with reference to Fig. 4.

Meanwhile, a process of repeating the sub-processes of recording various information about a grouping section in a database at least once by S360 is generally described below.

As one example, the power control unit 160 of the electric vehicle charging device 100 can set a cardinal number of units (which are counted as one group) as g within an entire time section of k to k+z which is a total section about t, and an i-th grouping section can be set as where the value of t is from (i-1)*g to i*(g-1). Herein, t can be understood as a variable, and k, z can be understood as a value for t.

For example, if g=60, a total of 60 unit data may correspond to one grouping section for use in calculating the accumulated electric energy.

If it is assumed that an i-th grouping section is where the value of t is from (i-1)*g to i*(g-1), during repeating the sub-processes while increasing the value of t from (i-1)*g to i*(g-1), the electric vehicle charging device 100 can additionally obtain accumulated electric energy information for an i-th group which is an accumulation of each piece of (i-1)*g-th electric energy information at a time of t being (i-1)*g to i*(g-1)-th electric energy information at a time of t being i*(g-1). Also, when t is i*(g-1), the electric vehicle charging device 100 can store and manage the (i-1)*g-th voltage to the i*(g-1)-th voltage, the (i-1)*g-th current to the i*(g-1)-th current, the (i-1)*g-th electric energy information to the i*(g-1)-th electric energy information and accumulated electric energy information for the i-th group in a database.

If S360 is performed for multiple times in this way, processes as following can be performed.

Specifically, after repeating charging and discharging for a first cycle to an s-th cycle, wherein s is an integer larger than or equal to 1, the electric vehicle charging device 100 can (1) estimate an s-th state of health (SOH) which is a ratio of an s-th maximum charging capacity to a first maximum charging capacity, by referring to (i) a (1_t)-th voltage and a (1_t)-th current measured from a (1_t)-th time to a (1_(t+1))-th time of a charging of the first cycle and (1_t)-th electric energy information obtained from the (1_t)-th voltage, the (1_t)-th current, the (1_t)-th time and the (1_(t+1))-th time, and (ii) an (s_t)-th voltage and an (s_t)-th current measured from an (s_t)-th time to an (s_(t+1))-th time of a charging of the s-th cycle and (s_t)-th electric energy information obtained from the (s_t)-th voltage, the (s_t)-th current, the (s_t)-th time and the (s_(t+1))-th time, and (2) reset the first threshold capacity to be a (1_s)-th threshold capacity for a charging of an (s+1)-th cycle of the electric vehicle battery by referring to the s-th state of health.

For example, with data of 2000 charging cycles of an electric vehicle battery of an 'A' electric vehicle, assuming that the 2001st cycle of charging of the electric vehicle battery of the 'A' electric vehicle is performed, the value of 100 kWh as the first maximum charging capacity in the first cycle and the value of 90 kWh as the 2000th maximum charging capacity in the 2000th cycle can be obtained by referring to the respective pieces of electric energy information obtained from the first charging cycle (which can be assumed as the time when the user signed up for the electric vehicle charging service for the first time) and 2000th charging cycle, and based on these, compensations can be made for the first threshold capacity and the second threshold capacity.

According to this, the electric vehicle charging device 100 can estimate that the ratio of the 2000th maximum charging capacity to the first maximum charging capacity, which corresponds to the 2000^{th} SOH, is 90%, and accordingly, for the 2001st charge of the electric vehicle battery, the 1_2000-th threshold capacity is set to 90% of the initial first threshold capacity, and because of this, even if usage time is accumulated, the usage time is reflected to safely charge the electric vehicle battery and prevent fire.

Also, after repeating charging and discharging from a first cycle to an s-th cycle, the electric vehicle charging device 100 can (i) perform a sub-process of measuring of a (1_t)-th current from a (1_t)-th time to a (1_(t+1))-th time of a charging of the first cycle to a sub-process of measuring an (s_t)-th current from an (s_t)-th time to an (s_(t+1))-th time of a charging of the s-th cycle, (ii) obtain each of frequency ranges, each of amplitudes, and each piece of spectrum information of each of the (1_t)-th current to the (s_t)-th current, and (iii) estimate a state of health of the electric vehicle battery at each cycle by referring to each of the frequency ranges, each of the amplitudes, and each piece of the spectrum information of each of the (1_t)-th current to the (s_t)-th current.

Sub-processes described as above are highly important due to the following phenomenon. That is, as the charging and the discharging repeat, the maximum charging capacity of the lithium ion battery can be reduced due to cases (i) in which lithium ions are trapped in the solid electrolyte interfacial (SEI) layer formed on the surface of the electrode, (ii) in which the electrolyte deteriorates due to a chemical reaction with the electrode material, an exposure to air, or a high temperature, and (iii) in which lithium dendrites, which are small needle-shaped structures, are generated on the surface of the electrode, and thus the structure of the separator is deformed, etc. Thus, the electric vehicle charging device 100 should compensate in order to stop the charging at the level where the electric vehicle battery can be safely charged by reflecting the reduction in charging capacity and life of electric vehicle battery.

Fig. 4 is a drawing schematically illustrating a result data acquired by analyzing the electric energy information of the electric vehicle charging device in accordance with one example embodiment of the present disclosure charging the electric vehicle.

Referring to Fig. 4, the electric vehicle charging device 100 detects that it is connected to the electric vehicle by the user using the plug to connect to the power outlet of the electric vehicle charging device 100 at 11:31, February 28, 2022.

After that, the electric vehicle charging device 100 can check the information on the electric energy charged to the electric vehicle battery in a graph from 11:31, February 28, 2022, when the charging begins, to 12:18, February 28, 2022, when the charging ends.

As one example, the electric vehicle charging device 100 can check that, for about 5 minutes from 11:31, February 28, 2022, as charging proceeds in a constant current charging mode under the condition that the electric vehicle battery has been discharged (a state where the battery voltage is low), the voltage applied to the both ends of the electric vehicle battery increases rapidly, and thus the charging power reaches 3.5 kW.

After that, the electric vehicle charging device 100 can continue charging with charging power of 3.5 kW being maintained, and when it is detected that a state of charge of the electric vehicle battery has reached a first threshold capacity 410 of 82%, the electric vehicle charging device 100 can detect change of the mode from the constant current charging mode to the constant voltage charging mode, and in order to maintain the charging voltage constant or change the charging voltage within a specific threshold range, it can be confirmed that as the current decreases, the power being charged gradually decreases.

Also, the electric vehicle charging device 100 can continue charging in the constant voltage charging mode where the charging power gradually decreases, and then when it is detected that the state of charge of the electric vehicle battery has reached a second threshold capacity 420 of 85% for example, in order to prevent fire and extend life of the electric vehicle battery, it can support to stop the charging of the electric vehicle battery, and accordingly it can check that the charging power of the electric vehicle battery rapidly reduces to 0kW, and the charging of the first cycle finishes.

Meanwhile, when the charging of the electric vehicle battery is performed, the electric vehicle charging device 100 can measure each of frequency ranges, each of amplitudes, and each piece of spectrum information for each of the first cycle to the s-th cycle by using an impedance spectroscopy, and it can also indirectly identify the degree of electrode defects, electrolyte impurities, and dendrite volume through the noise component that slightly changes the charging current, and referring to such information, the SOH of the electric vehicle battery at each charging cycle can be effectively estimated.

As one example, looking at the frequency range of the charging current, the noise component of the electrode defect ranges from several kHz to several MHz, the noise component of the electrolyte impurities ranges from several MHz to several kHz, and the noise component of the lithium dendrite ranges from several kHz to several MHz.

Also, looking at the amplitudes of the charging current, the noise component of the electrode defect has an amplitude value of several mV, the noise component of the electrolyte impurities has an amplitude value of several µV, and the noise component of the lithium dendrite has an amplitude value of several nV.

Also, looking at the spectrum information of the charging current, the noise component of the electrode defect has a narrowband spectrum with a single peak, and the noise component of the electrolyte impurities has a broad spectrum with multiple peaks.

Meanwhile, the electric vehicle charging device 100 can indirectly determine the volume of the lithium dendrite by using the impedance spectroscopy.

As one example, the electric vehicle charging device 100 can apply the test voltage signal ranging several kHz to the electric vehicle battery in order to measure the lithium dendrite, and calculate the impedance value of an electric vehicle battery by measuring the voltage applied at the both ends of the electric vehicle battery and the current flowing in the battery, and, the volume of the lithium dendrite can be quantified by calculating the difference from the impedance value measured at the test battery cell without the lithium dendrite.

Thus, by making it possible to recognize the electrode defect, the electrolyte impurities, the volume of lithium dendrite etc. indirectly, the state of health of the electric vehicle battery at each charging cycle can be effectively estimated.

Also, since the time-series cumulative charging data are recorded in the electric vehicle charging device 100, if the second-hand trading of electric vehicle batteries becomes active in the future, it could prove the reliability of the electric vehicle battery.

Further, when the electric vehicle battery further repeats the charging and discharging and the SOH becomes lower than 80%, it can be determined that the life of an electric vehicle battery has ended, and the electric vehicle battery can be used in ESS (Energy Storage System) such as wind power generation or solar power generation.

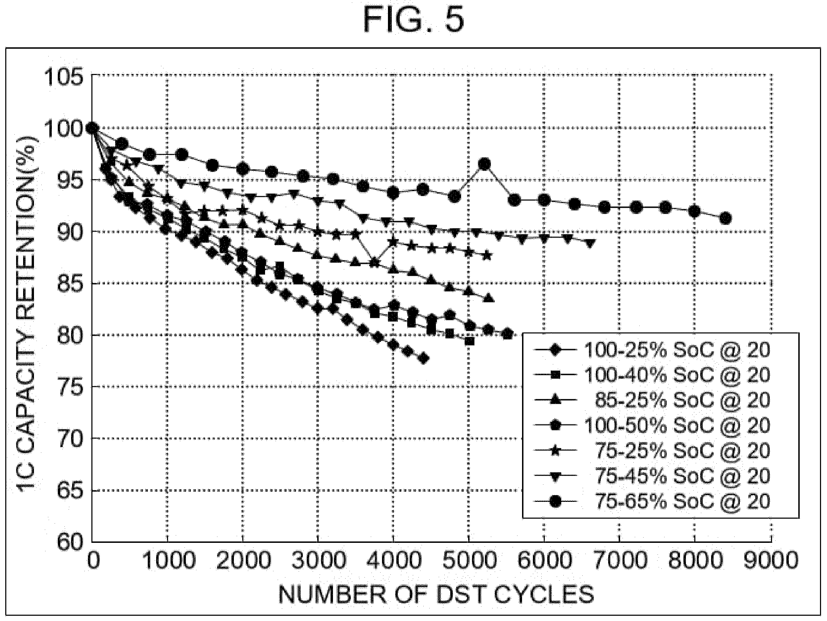

Fig. 5 is a drawing schematically illustrating a result data acquired by measuring a battery life of the electric vehicle battery with different ranges of a charging and discharging of the electric vehicle by the electric vehicle charging device in accordance with one example embodiment of the present disclosure.

Referring to Fig. 5, it shows the results of measuring the change in the charged charge capacity at least 4000 times when the electric vehicle charging device 100 charges the electric vehicle battery with 1C (that is, speed that allows charging to be completed in just 1 hour) at different charging and discharging ranges of 100%-25%, 100%-40%, 85%-25%, 100%-50%, 75%-25%, 75%-45% and 75%-65% respectively.

Herein, when the charging and discharging was performed with 100%-25%, the charging capacity became 90% when 1000 cycles were performed, 86% when 2000 cycles were performed, and reduced to less than 80%, which is about 79% when 4000 cycles were performed.

Generally, the life of an electric vehicle battery is determined as ended when it reaches 80% of its initial maximum charge capacity. When the 100%-25% range is used, the life of the electric vehicle battery ends before 4000 cycles of charging and discharging (for reference, it takes about 10 years to perform 4000 cycles of charging and discharging of the electric vehicle battery), and thus, it requires relatively frequent replacement and may not be determined as appropriate to use.

Meanwhile, in order to extend the life of the electric vehicle battery, the ranges of the charging and discharging can be changed. Comparing 100%-40% and 85%-25% which share the same bandwidth of 60%, based on performing 4000 cycles of charging and discharging, when using 100%-40% range of charging and discharging, the charging capacity became about 82% compared to the initial capacity, and when using 85%-25% range of charging and discharging, the charging capacity became about 86% compared to the initial capacity.

As another example, comparing 100%-50% and 75%-25% which share the same bandwidth of 50%, based on performing 4000 cycles of charging and discharging, when using 100%-50% range of charging and discharging, the charging capacity became about 83% compared to the initial capacity, and when using 75%-25% range of charging and discharging, the charging capacity became about 89% compared to the initial capacity.

Therefore, in order to efficiently extend the life of the electric vehicle battery, lowering the upper threshold of the range from 100% to a certain first value is most important thing to do, and raising the lower threshold of the range from 0% to a certain second value is the next important thing to do.

Herein, in case of using 75%-45% or 75%-65% which have a bandwidth of charging and discharging lower than 50% (which is the upper two graphs of Fig. 5), the life of electric vehicle battery may be extended numerically to the maximum extent possible, but in this case, the electric vehicle battery will be needed to charge too often, which may cause inconvenience in charging.

Thus, with reference to Fig. 5, considering a charging capacity, the time, the cost, the life of the electric vehicle battery, etc., performing the charging and discharging of the electric battery with 85%-25% range may be an optimal option considering the trade-off between battery life and the number of charging frequency.

However, the 85%-25% range of charging and discharging mentioned as the optimal option is only an example, and a specific optimal charging and discharging range which corresponds to at least part of the car type of the electric vehicle, the type of the electric vehicle battery, the use of the electric vehicles, the usage information of the electric vehicle battery, the temperature of the electric vehicle battery while charging and discharging may be determined.

For this purpose, by referring to the database which manages each piece of optimal charging and discharging range information for each of multiple electric vehicle batteries, wherein each piece of the optimal charging and discharging range information is matched with at least part of: the car types of multiple electric vehicles, the types of multiple electric vehicle batteries, the uses of the multiple electric vehicles, multiple pieces of the usage information of the multiple electric vehicle batteries, the temperatures of the multiple electric vehicle batteries while charging and discharging, the electric vehicle charging device 100 obtains the specific optimal charging and discharging range information which is matched with at least part of the car type of the electric vehicle, the type of the electric vehicle battery, the use of the electric vehicles, the usage information of the electric vehicle battery, the temperature of the electric vehicle battery while charging and discharging for the electric vehicle to be charged by the electric vehicle charging device 100.

Also, while monitoring the (i-1)*g-th electric energy information to the i*(g-1)-th electric energy information and the accumulated electric energy information for the i-th group, when it is detected to be an upper threshold corresponding to the specific optimal charging and discharging range information of the electric vehicle battery, the electric vehicle charging device 100 supports to stop the charging of the electric vehicle battery, and when it is detected to be a lower threshold corresponding to the specific optimal charging and discharging range information of the electric vehicle battery, the electric vehicle charging device 100 supports to stop the discharging of the electric vehicle battery and start a new cycle of charging.

Obviously, according to the number of the charging and discharging of the corresponding electric vehicle battery, the corresponding charging and discharging range information (i.e., adjusted upper threshold and/or adjusted lower threshold) may be loaded from the database and referred to.

In this case, during the process of recording and analyzing the trend of accumulated electric energy information for each time unit and accumulated electric energy information for each group by the processes mentioned above, the electric vehicle charging device 100 of the present disclosure can detect the upper threshold (or adjusted upper threshold) and the lower threshold (or adjusted lower threshold) corresponding to the charging and discharging range information as the optimal option, and when it is detected that the upper threshold (or adjusted upper threshold) corresponding to the charging and discharging range information as the optimal option is reached, it can support to stop the charging of the electric vehicle battery, and when it is detected that the lower threshold (or adjusted lower threshold) corresponding to the charging and discharging range information as the optimal option is reached, it can support to stop the discharging of the electric vehicle battery and start new cycle of charging.

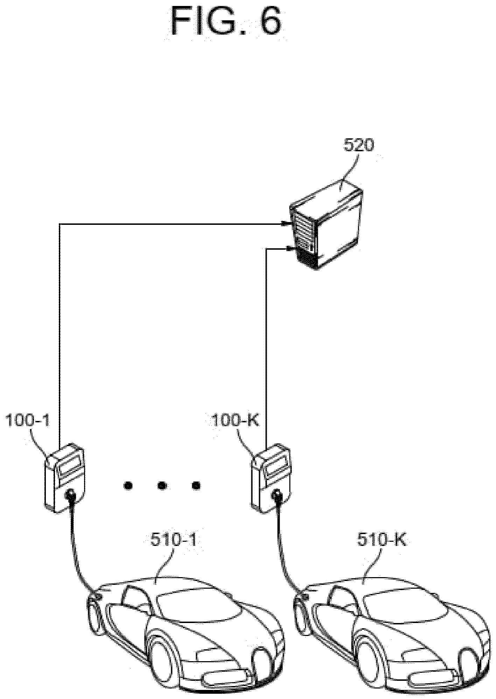

Fig. 6 is a drawing schematically illustrating a system for charging the electric vehicle in accordance with one example embodiment of the present disclosure.

Referring to Fig. 6, the system 500 for charging the electric vehicle can comprise k electric vehicle charging devices (100-1, ..., 100-k), and a server 520 which supports at least one of k electric vehicles (510-1, ..., 510-k) each corresponding to the k electric vehicle charging devices (100-1, ..., 100-k).

In the system 500 for charging the electric vehicle, a certain electric vehicle charging device 100 among the k electric vehicle charging devices (100-1, ..., 100-k), can request the user to enter the user authentication information to the user authentication unit 140 when it is determined that a certain electric vehicle 510 corresponding to the certain electric vehicle charging device 100 is connected to the power outlet 130. Then, when the user identification information is entered within the predetermined authentication waiting time, the certain electric vehicle charging device 100 performs the user authentication with reference to the entered information, and it can maintain the charging power or cut the power supply to the certain electric vehicle 510 according to the result.

Next, the processor 120 of the certain electric vehicle charging device 100, in a state where the charging power supplied to the certain electric vehicle 510 which is connected to the certain electric vehicle charging device is maintained corresponding to the user authentication result, can measure the electric energy according to the charging power supplied to the certain electric vehicle 510 at the power information detection unit 150, and the measured electric energy can be recorded with matching information about the user of the certain electric vehicle 510.

Also, the processor 120 of the certain electric vehicle charging device 100, in a state where the charging power supplied to the certain electric vehicle 510 which is connected to the certain electric vehicle charging device is maintained corresponding to the user authentication result, when it is detected that the charging power supplied to the certain electric vehicle 510 has reached the predetermined first threshold capacity, can detect the change of mode from the constant current charging mode to the constant voltage charging mode, and when it maintains charging in the constant voltage charging mode and detects that it has reached the predetermined second threshold capacity, it can determine that the charging of the certain electric vehicle 510 has been ended and can support to stop the charging.

Herein, when the charging of the certain electric vehicle 510 is completed and the certain electric vehicle 510 is separated from the certain electric vehicle charging device 100 and when it is confirmed that the certain electric vehicle charging device 100 is at a state with no load, the processor 120 of the certain electric vehicle charging device 100 can stop the measuring of charging power about the certain electric vehicle 510, and by obtaining the amount of the charging power about the certain electric vehicle 510 from the start of the measurement to the end as a final charged electric energy corresponding to the user of the certain electric vehicle 510, the payment according to the final charged electric energy by the user of the certain electric vehicle 510 may be possible.

Also, the processor 120 of the certain electric vehicle charging device 100 can transmit the information about the final charged electric energy to the server 520, and thereby support to manage the total used electric energy measured by the certain electric vehicle charging device 100 and the final charged electric energy separately.

Herein, the processor 120 of the certain electric vehicle charging device 100 can separately generate the usage information including the obtained final charged electric energy and store or transmit to the server 520, wherein this can further include information such as the user information, start time of a measurement, the measurement corresponding to the start time, end time of the measurement, the measurement corresponding to the end time, the status of the certain electric vehicle charging device 100, attempts to transmit to the server and time of transmit.

The present disclosure has an effect of providing a function for controlling the charging rate of the electric battery by detecting that a predetermined first threshold capacity is reached during a constant current charging mode and then by detecting the change from the constant current charging mode to a constant voltage charging mode where a charging voltage is maintained constantly.

The present disclosure has another effect of providing an electric vehicle charging device for providing a function of preventing the fire by stopping charging of the electric vehicle battery at an appropriate timing when it is detected that it has reached a predetermined second threshold capacity, while charging in the constant voltage charging mode, during a safety mode.

The present disclosure has still another effect of providing the electric vehicle charging device for effectively estimating the state of health of the electric vehicle battery by referring to the data of repeated charging cycles of the electric vehicle battery, and resetting the first threshold capacity based on the estimated state of health of the battery.

The present disclosure has still another effect of providing the electric vehicle charging device for effectively evaluating the state of health of the electric vehicle battery of each cycle by referring to each of frequency ranges, each of amplitudes, and each piece of spectrum information obtained from the data of the repeated charging cycles of the electric vehicle battery.

Also, the embodiments of the present disclosure as explained above can be implemented in a form of executable program command through a variety of computer means recordable in computer readable media. The computer readable media may include solely or in combination, program commands, data files, and data structures. The program commands recorded in the media may be components specially designed for the present disclosure or may be usable to those skilled in the art in a field of computer software. Computer readable media may include magnetic media such as hard disk, floppy disk, and magnetic tape, optical media such as CD-ROM and DVD, magneto-optical media such as floptical disk and hardware devices such as ROM, RAM, and flash memory specially designed to store and carry out program commands. Program commands may include not only a machine language code made by a complier but also a high-level code that can be used by an interpreter etc., which may be executable by a computer. The aforementioned hardware device can work as more than a software module to perform the action of the present disclosure and they can do the same in the opposite case.

As seen above, the present disclosure has been explained by specific matters such as detailed components, limited embodiments, and drawings. They have been provided only to help more general understanding of the present disclosure. It, however, will be understood by those skilled in the art that various changes and modification may be made from the description without departing from the spirit and scope of the disclosure as defined in the following claims.

Accordingly, the thought of the present disclosure must not be confined to the explained embodiments, and the following patent claims as well as everything including variations equal or equivalent to the patent claims pertain to the category of the thought of the present disclosure.

## Claims

1. A method for safely and efficiently charging an electric vehicle using an electric vehicle charging device equipped with an electric vehicle fire prevention function and a battery performance evaluation function, comprising steps of:
(a) after the electric vehicle is connected to the electric vehicle charging device, the electric vehicle charging device starting a charging of an electric vehicle battery in a constant current charging mode in which a charging current is maintained to be constant; and
(b) the electric vehicle charging device repeating sub-processes of (i) measuring a t-th voltage which is a charging voltage applied between both ends of the electric vehicle battery from a t-th time to a (t+1)-th time and a t-th current which is the charging current flowing through the electric vehicle battery from the t-th time to the (t+1)-th time, and (ii) obtaining t-th electric energy information by referring to the t-th voltage, the t-th current, the t-th time and the (t+1)-th time, while increasing a value of t;
wherein, at the step of (b), during repeating the sub-processes while increasing the value of t from k to k+z, when the value of t is k+m, wherein m is an integer larger than or equal to 0 and smaller than or equal to z, and when it is detected that a state of charge (SOC) of the electric vehicle battery has reached a predetermined first threshold capacity, the electric vehicle charging device changes its mode from the constant current charging mode to a constant voltage charging mode, wherein, in the constant voltage charging mode, the electric vehicle is charged with the charging voltage being maintained constantly as a specific voltage or with the charging voltage being changed within a specific threshold range.

2. The method of Claim 1, further comprising a step of:
(c) during repeating the sub-processes while increasing the value of t from k to k+z, when the value of t is k+n, wherein n is an integer larger than or equal to 1 and smaller than or equal to z, and when it is detected that the state of charge of the electric vehicle battery has reached a predetermined second threshold capacity, the electric vehicle charging device supporting to stop charging the electric vehicle battery.

3. The method of Claim 1, further comprising a step of:
(d) after repeating charging and discharging for a first cycle to an s-th cycle, wherein s is an integer larger than or equal to 1, the electric vehicle charging device (d1) estimating an s-th state of health (SOH) which is a ratio of an s-th maximum charging capacity to a first maximum charging capacity, by referring to (i) a (1_t)-th voltage and a (1_t)-th current measured from a (1_t)-th time to a (1_(t+1))-th time of a charging of the first cycle and (1_t)-th electric energy information obtained from the (1_t)-th voltage, the (1_t)-th current, the (1_t)-th time and the (1_(t+1))-th time, and (ii) an (s_t)-th voltage and an (s_t)-th current measured from an (s_t)-th time to an (s_(t+1))-th time of a charging of the s-th cycle and (s_t)-th electric energy information obtained from the (s_t)-th voltage, the (s_t)-th current, the (s_t)-th time and the (s_(t+1))-th time, and (d2) the electric vehicle charging device resetting the first threshold capacity to be a (1_s)-th threshold capacity for a charging of an (s+1)-th cycle of the electric vehicle battery by referring to the s-th state of health.

4. The method of Claim 1, further comprising a step of:
(e) after repeating charging and discharging from a first cycle to an s-th cycle, the electric vehicle charging device (e1) performing a sub-process of measuring of a (1_t)-th current from a (1_t)-th time to a (1_(t+1))-th time of a charging of the first cycle to a sub-process of measuring an (s_t)-th current from an (s_t)-th time to an (s_(t+1))-th time of a charging of the s-th cycle, (e2) obtaining each of frequency ranges, each of amplitudes, and each piece of spectrum information of each of the (1_t)-th voltage to the (s_t)-th voltage, and (e3) estimating a state of health of the electric vehicle battery at each cycle by referring to each of the frequency ranges, each of the amplitudes, and each piece of the spectrum information of each of the (1_t)-th voltage to the (s_t)-th voltage.

5. The method of Claim 1, wherein, at the step of (b), in the constant current charging mode, during repeating the sub-processes while increasing the value of t from k to k+m, the electric vehicle charging device increases the charging voltage applied between the both ends of the electric vehicle battery by maintaining the charging current of the electric vehicle battery to be constant, and when it is detected that the charging voltage has reached a predetermined safety charging end voltage for a fire prevention and an extended life of the electric vehicle battery, the electric vehicle charging device detects that its mode has been changed from the constant current charging mode to the constant voltage charging mode.

6. The method of Claim 1, wherein, at the step of (b), when there are g number of units which are counted as one group in a section of k to k+z which is a total section about t, and when an i-th grouping section is where the value of t is from (i-1)*g to i*(g-1), during repeating the sub-processes while increasing the value of t from (i-1)*g to i*(g-1), the electric vehicle charging device additionally obtains accumulated electric energy information for an i-th group which is an accumulation of each of (i-1)*g-th electric energy information at a time of t being (i-1)*g to i*(g-1)-th electric energy information at a time of t being i*(g-1),
and wherein the electric vehicle charging device stores and manages the (i-1)*g-th voltage to the i*(g-1)-th voltage, the (i-1)*g-th current to the i*(g-1)-th current, the (i-1)*g-th electric energy information to the i*(g-1)-th electric energy information and accumulated electric energy information for the i-th group in a database.

7. The method of Claim 6, wherein, by referring to the database which manages each piece of optimal charging and discharging range information for each of multiple electric vehicle batteries, wherein each piece of the optimal charging and discharging range information is matched with at least part of: car types of multiple electric vehicles, types of multiple electric vehicle batteries, uses of the multiple electric vehicles, multiple pieces of usage information of the multiple electric vehicle batteries, temperatures of the multiple electric vehicle batteries while charging and discharging, the electric vehicle charging device obtains specific optimal charging and discharging range information which is matched with at least part of: the car type of the electric vehicle, the type of the electric vehicle battery, the use of the electric vehicles, the usage information of the electric vehicle battery, the temperature of the electric vehicle battery while charging and discharging,
and wherein, while monitoring the (i-1)*g-th electric energy information to the i*(g-1)-th electric energy information and accumulated electric energy information for the i-th group, when it is detected to be an upper threshold corresponding to the specific optimal charging and discharging range information of the electric vehicle battery, the electric vehicle charging device supports to stop the charging of the electric vehicle battery, and when it is detected to be a lower threshold corresponding to the specific optimal charging and discharging range information of the electric vehicle battery, the electric vehicle charging device supports to stop the discharging of the electric vehicle battery and start a new cycle of charging.

8. The method of Claim 1, before the step of (a), further comprising a step of:
(a0) when it is detected that the electric vehicle is connected to the electric vehicle charging device, the electric vehicle charging device (a01) automatically selecting one of a safety mode which is a mode that is capable of charging the electric vehicle battery safely by applying the electric vehicle fire prevention function and a long distance mode which is a mode that can charge up to a maximum charge capacity of the electric vehicle battery for a long distance driving of the electric vehicle, or (a02) supporting a user of the electric vehicle to select one of the safety mode and the long distance mode;
wherein, (i) when it is detected that the safety mode is selected, the electric vehicle charging device performs the steps (a) and (b), and during repeating the sub-processes while increasing the value of t from k to k+z, when the value of t is k+n and when it is detected that the state of charge of the electric vehicle battery has reached a predetermined second threshold capacity, the electric vehicle charging device stops the charging of the electric vehicle, and (ii) when it is detected that the long distance mode is selected, the electric vehicle charging device performs the steps (a) and (b), and during repeating the processes while increasing the value of t from k to k+z, when the value of t is k+n, the electric vehicle charging device continues charging without detecting whether the state of charge of the electric vehicle battery reaches the predetermined second threshold capacity or not.

9. An electric vehicle charging device being equipped with an electric vehicle fire prevention function and a battery performance evaluation function, comprising:
at least one memory that stores instructions; and
at least one processor configured to execute the instructions to perform or support another device to perform processes of: (I) after the electric vehicle is connected to the electric vehicle charging device, the electric vehicle charging device starting a charging of an electric vehicle battery in a constant current charging mode in which a charging current is maintained to be constant; and (II) the electric vehicle charging device repeating sub-processes of (i) measuring a t-th voltage which is a charging voltage applied between both ends of the electric vehicle battery from a t-th time to a (t+1)-th time and a t-th current which is the charging current flowing through the electric vehicle battery from the t-th time to the (t+1)-th time, and (ii) obtaining t-th electric energy information by referring to the t-th voltage, the t-th current, the t-th time and the (t+1)-th time, while increasing a value of t; wherein, at the process (II), during repeating the sub-processes while increasing the value of t from k to k+z, when the value of t is k+m, wherein m is an integer larger than or equal to 0 and smaller than or equal to z, and when it is detected that a state of charge (SOC) of the electric vehicle battery has reached a predetermined first threshold capacity, the electric vehicle charging device changes its mode from the constant current charging mode to a constant voltage charging mode, wherein, in the constant voltage charging mode, the electric vehicle is charged with the charging voltage being maintained constantly as a specific voltage or with the charging voltage being changed within a specific threshold range.

10. The device of Claim 9, the processor further performing a process of:
(III) during repeating the sub-processes while increasing the value of t from k to k+z, when the value of t is k+n, wherein n is an integer larger than or equal to 1 and smaller than or equal to z, and when it is detected that the state of charge of the electric vehicle battery has reached a predetermined second threshold capacity, the electric vehicle charging device supporting to stop charging the electric vehicle battery.

11. The device of Claim 9, the processor further performing a process of:
(IV) after repeating charging and discharging for a first cycle to an s-th cycle, wherein s is an integer larger than or equal to 1, the electric vehicle charging device (IV-1) estimating an s-th state of health (SOH) which is a ratio of an s-th maximum charging capacity to a first maximum charging capacity, by referring to (i) a (1_t)-th voltage and a (1_t)-th current measured from a (1_t)-th time to a (1_(t+1))-th time of a charging of the first cycle and (1_t)-th electric energy information obtained from the (1_t)-th voltage, the (1_t)-th current, the (1_t)-th time and the (1_(t+1))-th time, and (ii) an (s_t)-th voltage and an (s_t)-th current measured from an (s_t)-th time to an (s_(t+1))-th time of a charging of the s-th cycle and (s_t)-th electric electric energy information obtained from the (s_t)-th voltage, the (s_t)-th current, the (s_t)-th time and the (s_(t+1))-th time, and (IV-2) the electric vehicle charging device resetting the first threshold capacity to be a (1_s)-th threshold capacity for a charging of an (s+1)-th cycle of the electric vehicle battery by referring to the s-th state of health.

12. The device of Claim 9, the processor further performing a process of:
(V) after repeating charging and discharging from a first cycle to an s-th cycle, the electric vehicle charging device (V-1) performing a sub-process of measuring of a (1_t)-th current from a (1_t)-th time to a (1_(t+1))-th time of a charging of the first cycle to a sub-process of measuring an (s_t)-th current from an (s_t)-th time to an (s_(t+1))-th time of a charging of the s-th cycle, (V-2) obtaining each of frequency ranges, each of amplitudes, and each piece of spectrum information of each of the (1_t)-th voltage to the (s_t)-th voltage, and (V-3) estimating a state of health of the electric vehicle battery at each cycle by referring to each of the frequency ranges, each of the amplitudes, and each piece of the spectrum information of each of the (1_t)-th voltage to the (s_t)-th voltage.

13. The device of Claim 9, wherein, at the process of (II), in the constant current charging mode, during repeating the sub-processes while increasing the value of t from k to k+m, the electric vehicle charging device increases the charging voltage applied between the both ends of the electric vehicle battery by maintaining the charging current of the electric vehicle battery to be constant, and when it is detected that the charging voltage has reached a predetermined safety charging end voltage for a fire prevention and an extended life of the electric vehicle battery, the electric vehicle charging device detects that its mode has been changed from the constant current charging mode to the constant voltage charging mode.

14. The device of Claim 9, wherein, at the process of (II), when there are g number of units which are counted as one group in a section of k to k+z which is a total section about t, and when an i-th grouping section is where the value of t is from (i-1)*g to i*(g-1), during repeating the sub-processes while increasing the value of t from (i-1)*g to i*(g-1), the electric vehicle charging device additionally obtains accumulated electric energy information for an i-th group which is an accumulation of each of (i-1)*g-th electric energy information at a time of t being (i-1)*g to i*(g-1)-th electric energy information at a time of t being i*(g-1),
and wherein the electric vehicle charging device stores and manages the (i-1)*g-th voltage to the i*(g-1)-th voltage, the (i-1)*g-th current to the i*(g-1)-th current, the (i-1)*g-th electric energy information to the i*(g-1)-th electric energy information and accumulated electric energy information for the i-th group in a database.

15. The device of Claim 14, wherein, by referring to the database which manages each piece of optimal charging and discharging range information for each of multiple electric vehicle batteries, wherein each piece of the optimal charging and discharging range information is matched with at least part of: car types of multiple electric vehicles, types of multiple electric vehicle batteries, uses of the multiple electric vehicles, multiple pieces of usage information of the multiple electric vehicle batteries, temperatures of the multiple electric vehicle batteries while charging and discharging, the electric vehicle charging device obtains specific optimal charging and discharging range information which is matched with at least part of: the car type of the electric vehicle, the type of the electric vehicle battery, the use of the electric vehicles, the usage information of the electric vehicle battery, the temperature of the electric vehicle battery while charging and discharging,
and wherein, while monitoring the (i-1)*g-th electric energy information to the i*(g-1)-th electric energy information and accumulated electric energy information for the i-th group, when it is detected to be an upper threshold corresponding to the specific optimal charging and discharging range information of the electric vehicle battery, the electric vehicle charging device supports to stop the charging of the electric vehicle battery, and when it is detected to be a lower threshold corresponding to the specific optimal charging and discharging range information of the electric vehicle battery, the electric vehicle charging device supports to stop the discharging of the electric vehicle battery and start a new cycle of charging.

16. The device of Claim 9, before the process of (I), the processor further performing a process of:
(I-0) when it is detected that the electric vehicle is connected to the electric vehicle charging device, the electric vehicle charging device (I-01) automatically selecting one of a safety mode which is a mode that is capable of charging the electric vehicle battery safely by applying the electric vehicle fire prevention function and a long distance mode which is a mode that can charge up to a maximum charge capacity of the electric vehicle battery for a long distance driving of the electric vehicle, or (I-02) supporting a user of the electric vehicle to select one of the safety mode and the long distance mode;
wherein, (i) when it is detected that the safety mode is selected, the electric vehicle charging device performs the processes (I) and (II), and during repeating the sub-processes while increasing the value of t from k to k+z, when the value of t is k+n and when it is detected that the state of charge of the electric vehicle battery has reached a predetermined second threshold capacity, the electric vehicle charging device stops the charging of the electric vehicle, and (ii) when it is detected that the long distance mode is selected, the electric vehicle charging device performs the steps (a) and (b), and during repeating the processes while increasing the value of t from k to k+z, when the value of t is k+n, the electric vehicle charging device continues charging without detecting whether the state of charge of the electric vehicle battery reaches the predetermined second threshold capacity or not.
